# EUROPEAN PATENT APPLICATION

(11) **EP 4 343 041 A1**
(43) Date of publication of application: **27.03.2024**
(21) Application number: 23188815.7
(22) Date of filing: 31.07.2023
(51) Int. Cl.: C30B 11/00, C30B 29/46, C30B 29/68

(54) **METHOD FOR PRODUCING THREE-DIMENSIONAL TI MICRO- OR NANOHETEROSTRUCTURE AND TI MICRO- OR NANOHETEROSTRUCTURE OBTAINED BY THIS METHOD**

(30) Priority: 29.07.2022 PL 44188322; 30.07.2023 PL 44571223
(71) Applicant: Ensemble3 spolka z ograniczona odpowiedzialnoscia, 01-919 Warszawa (PL)
(72) Inventor: PAWLAK, Dorota Anna, 01-885 Warszawa (PL); BANDOPADHYAY, Kingshuk, 01-840 Warszawa (PL); MATERNA, Andrzej, 03-455 Warszawa (PL); MARKUS, Krzysztof, 01-919 Warszawa (PL); KUROWSKA, Marta, 01-919 Warszawa (PL)
(74) Representative: JD&P Patent Attorneys Joanna Dargiewicz & Partners

(57) **Abstract**

The object of the invention is a method of producing a three-dimensional TI micro- or nano-heterostructure characterized by the fact that, directional crystallization of a single-phase liquid of eutectic, peri-eutectic i.e. supereutectic or subeutectic into at least two-phase composite heterostructures, the resulting composite heterostructures containing a topological insulator TI and another material, which other material is selected from a group including one or more insulator, semiconductor, metal, other Tl, ferroelectric material, ferromagnetic material, superconductor, optically active material. Another object of the invention is a three-dimensional micro- or nano-heterostructure of TI produced by the method according to the invention, characterized in that it is multilayered and is a eutectic, peri-eutectic, super-eutectic or sub-eutectic composite consisting of at least two crystalline phases comprising a phase of TI and a phase of another material, which other material is selected from a group including one or more of an insulator, semiconductor, metal, other Tl, ferroelectric material, ferromagnetic material, semiconductor, optically active material.

## Description

The subject of the invention is a method of producing a three-dimensional TI micro- or nano-heterostructure and a TI micro- or nano-heterostructure produced by this method.

The traditional classification of materials by electrical properties included three categories: insulators, semiconductors, and metals. Meanwhile, at the beginning of the 21st century, a new class of materials was shown to transcend this classification scheme (Moore JE. The birth of topological insulators. Nature 2010, 464(7286): 194-198*).*

These materials, now called topological insulators (Tl) (Moore JE, Balents L. Topological invariants of time-reversal-invariant band structures. Physical Review β 2007, 75(12). doi:10.1103/PhysRevB.75.121306*).* A topological insulator is a chemically homogeneous material that has insulating properties in its volume, while metallic conducting states are formed on its surface. This is due to the inversion of the energy bands of a given topological insulator around the Fermi level.

The metallic surface states are the result of a strong spin-orbit coupling that causes a permanent reversal of the valence bands and conductivity (Hsieh D, Qian D, Wray L, Xia Y, Hor YS, Cava RJ, et al. A topological Dirac insulator in a quantum spin Hall phase. Nature 2008, 452(7190): 970-974. doi:10.1038/nature06843*).* Strong spin-orbit coupling occurs mainly in materials with high mass numbers.

The use of topological insulators has great potential in the development of fields such as spintronics, quantum computing, or, for example, in the design of modern detectors, various magnetic devices, etc. In a 2007 paper by König et al (König M, Wiedmann S, Brüne C, Roth A, Buhmann H, Molenkamp LW, et al. Quantum Spin Hall Insulator State in HgTe Quantum Wells. Science 2007, 318(5851): 766. doi:10.1126/science.1148047*)* the authors showed the feasibility of two-dimensional Tl materials with a conductive edge, while three-dimensional (3D) materials were presented in a 2009 paper by Hsieh et al. (Hsieh D, Xia Y, Wray L, Qian D, Pal A, Oil JH, et al. Observation of Unconventional Quantum Spin Textures in Topological Insulators. Science 2009, 323(5916): 919. doi:10.1126/science*).*

However, there are several problems that pose significant difficulties in the practical application of topological insulators. The first important limitation is the masking of surface electron effects by volume electrons, due to the small surface-to-volume ratio in a Tl monocrystal. There are several ways to overcome this difficulty:
- lowering the amount of free carriers in the volume of the material by doping the Tl;
- strictly controlling the stoichiometry, in order to minimize structural defects (vacancies, antisite defects, etc.);
- an alternative approach is to increase the surface-to-volume ratio and consequently increase the proportion of surface carriers.

Secondly, TI materials are very sensitive to atmospheric factors, as their surface degrades after a few minutes of exposure and deteriorates the transport properties of surface states. Thirdly, in order to use Tl materials in applications, it is necessary to form different types of junctions between Tl and other materials.

Most of these disadvantages can be minimized by using heterostructured systems in place of single crystals (Hesjedal T, Chen Y. Topological insulators: Engineered heterostructures. Nat Mater 2016, 16(1): 3-4. doi:10.1038/nmat4835*).* However, the known and currently used epitaxial methods for producing Tl heterostructures are costly and multi-step. These methods include physical vapor phase deposition (Chong SK, Han KB, Nagaoka A, Tsuchikawa R, Liu R, Liu H, et al. Topological Insulator- Based van der Waals Heterostructures for Effective Control of Massless and Massive Dirac Fermions. Nano Letters 2018, 18(12): 8047-8053. doi:10.1021/acs.nanolett*)* or molecular beam epitaxy (Richardella A, Kandala A, Samarth N. Topological Insulator Thin Films and Heterostructures: Epitaxial Growth, Transport, and Magnetism. Topological Insulators, 2015, pp 295-329*).*

The ability to manufacture heterostructures in a simple technological process, therefore, may be crucial for the efficient manufacturing of TI-based devices.

In view of the above, the purpose of the invention is to develop an efficient and cost-optimal way to manufacture these heterostructures.

The essence of the invention is a method for producing a three-dimensional TI micro- or nano-heterostructure, synthesized in that directional crystallization of a single-phase liquid of eutectic, peri-eutectic, i.e. supereutectic or subeutectic into at least two-phase composite heterostructures, with the resulting composite heterostructures containing a TI topological insulator and another material, which other material is selected from a group including one or more insulator, semiconductor, metal, other Tl, ferroelectric material, ferromagnetic material, superconductor, optically active material.

Preferably, the Tl is selected from the group including Bi₂Te₃, Bi₂Se₃, Sb₂Te₃, Bi₁₋ₓSbₓ, Bi₂Te₂Se, (Bi,Sb)₂Te₃, Bi₂₋ₓSbₓTe_{3-y}Se_{y}, Bi₂Te_{1.6}S_{1.4}, Bi_{1.1}Sb_{0.9}Te₂S, Sb₂Te₂Se, Bi₂(Te,Se)₂(Se,S), TlBiSe₂, TlBiTe₂, TlBi(S,Se)₂, PbBi₂Te₄, PbSb₂Te₄, GeBi₂Te₄, PbBi₄Te₇, GeBi₄₋ₓSbₓTe₇, (PbSe)₅(Bi₂Se₃)₆, (Bi₂)(Bi₂Se_{2.6}S_{0.4}), (Bi₂)(Bi₂Te₃)₂, SnTe, Pb₁₋ₓSnₓTe, Pb_{0.77}Sn_{0.23}Se, Ag₂Te, SmB₆, Bi₁₄Rh₃I₉, Pb₅Bi₂₄Se₄₁.

Preferably, another material is selected from the group including Te, Mn, Au, BiTel, GdTe₂, Sb₂Se₃, SbTeI, Fe₇Se₈, FeSe, GdBiTe₃, MnSb₂Te₄, HgTe, In₂Se₃, SnBi₄Te₇, EuBi₄Te₇, CdSe, HgSe, MnSb₄Te₇.

Preferably, the speed of directional crystallization was from 0.04 mm/hr to 200 mm/hr, preferably it is 25 mm/hr.

Whereby, the speed of crystallization can be from very low, such as 0.04 mm/hr resulting in heterostructures of significant size, for example, several hundred micrometers, through medium speeds such as 25 mm/hr allowing to obtain heterostructures of micrometric dimensions to high crystallization speeds such as several tens of millimeters per second allowing to obtain nanometer-scale separations. It should be noted that a given crystallization speed will also be closely related to the volume of crystallized material.

Preferably, the substrates used for directional crystallization are selected from a group including Bi, Te, Se, Sb, PbTe, GeTe, SnTe, PbSe, Ag₂Te, Sm, B, Tl₂Se, Tl₂Te₃, SbI₃, BiI₃.

Another embodiment according to the invention is a three-dimensional micro or nanoheterostructure of Tl produced by the method according to the invention, characterized in that it is multilayered and constitutes a eutectic or sub-eutectic, supereutectic or subeutectic composite consisting of at least two crystalline phases comprising a Tl phase and a phase of another material, which other material is selected from the group comprising one or more of an insulator, semiconductor, metal, other Tl, ferroelectric material, ferromagnetic material, superconductor, optically active material.

Preferably, the Tls are in the form of micro/nanofibers, micro/nanoplates, micro/nanospheres, or formations of other shapes, made of materials with topologically protected surface states.

Preferably, the three-dimensional micro or nanoheterostructure of the Tl according to the invention includes the elements Bi, Te, Sb, or a combination thereof.

The preferably three-dimensional micro or nanoheterostructure of Tl preferably to the invention is a eutectic/ supereutectic / subeutectic Bi₂Te₃-Te composite, preferably in a volume ratio of about 31:69.

The preferably three-dimensional micro or nanoheterostructure of Tl according to the invention is a eutectic/ supereutectic / subeutectic composite of Sb₂Te₃-Te, preferably in a volume ratio of about 24:76.

The preferably three-dimensional micro or nanoheterostructure of Tl according to the invention is a eutectic/ supereutectic / subeutectic composite of Bi₂Te₃-BiTeI, preferably in a volume ratio of about 30:70.

The preferably three-dimensional micro or nanoheterostructure of Tl according to the invention is a eutectic/ supereutectic / subeutectic composite of Bi₂Te₃-GdBiTe₃, preferably in a volume ratio of about 83:17.

The preferably three-dimensional micro or nanoheterostructure of Tl according to the invention is a eutectic/ supereutectic / subeutectic composite of Sb₂Se₃-Sb₂Te₃, preferably in a volume ratio of about 82: 18.

The preferably three-dimensional micro or nanoheterostructure of Tl according to the invention is a eutectic/ supereutectic / subeutectic composite of Bi₂Te₃-HgTe, preferably in a volume ratio of about 37: 63.

The preferably three-dimensional micro or nanoheterostructure of Tl according to the invention is a eutectic/ supereutectic / subeutectic composite of Sb₂Te₃₋MnSb₂Te₄, preferably in a volume ratio of about 85: 15.

The preferably three-dimensional micro or nanoheterostructure of Tl according to the invention is a eutectic/ supereutectic / subeutectic composite of Sb₂Te₃-SbTeI, preferably in a volume ratio of about 74: 26.

The preferably three-dimensional micro or nanoheterostructure of Tl according to the invention is a eutectic/ supereutectic / subeutectic composite of Bi₂Te₃-In₂Se₃, preferably in a volume ratio of about 88: 12.

The preferably three-dimensional micro or nanoheterostructure of Tl according to the invention is a eutectic/ supereutectic / subeutectic composite of Sb₂Te₃-HgTe, preferably in a volume ratio of about 32: 68.

The preferably three-dimensional micro or nanoheterostructure of Tl according to the invention is a eutectic/ supereutectic / subeutectic composite of Sb₂Te₃-GdSbTe₃, preferably in a volume ratio of about 92: 8.

The preferably three-dimensional micro or nanoheterostructure of Tl according to the invention is a eutectic/ supereutectic / subeutectic composite of Bi₂Te₃-In₂Se₃, preferably in a volume ratio of about 88: 12.

The preferably three-dimensional micro or nanoheterostructure of Tl according to the invention is a eutectic/ supereutectic / subeutectic composite with a topological phase selected from Bi₂Te₃, Bi₂Se₃, Sb₂Te₃, Bi₁₋ₓSbₓ, Bi₂Te₂Se, (Bi,Sb)₂Te₃, Bi₂₋ₓSbₓTe_{3-y}Se_{y}, Bi₂Te_{1.6}S_{1.4}, Bi_{1.1}Sb_{0.9}Te₂S, Sb₂Te₂Se, Bi₂(Te,Se)₂(Se,S), TlBiSe₂, TlBiTe₂, TlBi(S,Se)₂, PbBi₂Te₄, PbSb₂Te₄, GeBi₂Te₄, PbBi₄Te₇, GeBi₄₋ₓSbₓTe₇, (PbSe)₅(Bi₂Se₃)₆, (Bi₂)(Bi₂Se_{2.6}S_{6.4}), (Bi₂)(Bi₂Te₃)₂, SnTe, Pb₁₋ₓSnₓTe, Pb_{0.77}Sn_{0.23}Se, Ag₂Te, SmB₆, Bi₁₄Rh₃I₉, Pb₅Bi₂₄Se₄₁ and other topological insulators, along with an adjacent phase selected from metal, semiconductor, dielectric, superconductor, ferromagnetic, antiferromagnetic, ferroelectric, other topological insulators.

The preferably three-dimensional micro or nanoheterostructure of Tl according to the invention is a eutectic/ supereutectic / subeutectic composite with a topological phase selected from Bi₂Te₃, Bi₂Se₃, Sb₂Te₃, Bi₁₋ₓSbₓ, Bi₂Te₂Se, (Bi,Sb)₂Te₃, Bi₂₋ₓSbₓTe_{3-y}Se_{y}, Bi₂Te_{1.6}S_{1.4}, Bi_{1.1}Sb_{0.9}Te₂S, Sb₂Te₂Se, Bi₂(Te,Se)₂(Se,S), TlBiSe₂, TlBiTe₂, TlBi(S,Se)₂, PbBi₂Te₄, PbSb₂Te₄, GeBi₂Te₄, PbBi₄Te₇, GeBi₄₋ₓSbₓTe₇, (PbSe)₅(Bi₂Se₃)₆, (Bi₂)(Bi₂Se_{2.6}S_{6.4}), (Bi₂)(Bi₂Te₃)₂, SnTe, Pb₁₋ₓSnₓTe, Pb_{0.77}Sn_{0.23}Se, Ag₂Te, SmB₆, Bi₁₄Rh₃I₉, Pb₅Bi₂₄Se₄ and other topological insulators, along with an adjacent phase selected from metal, semiconductor, dielectric, superconductor, ferromagnetic, antiferromagnetic, ferroelectric, other topological insulators.

The advantageously three-dimensional micro or nanoheterostructure of TI according to the invention is a eutectic/ supereutectic / subeutectic composite with a topological phase selected from Bi₂Te₃, Bi₂Se₃, Sb₂Te₃, Bi1-xSbx, Bi₂Te₂Se, (Bi,Sb)₂Te₃, Bi₂₋ₓSbₓTe_{3-y}Se_{y}, Bi₂Te_{1.6}S_{1.4}, Bi_{1.1}Sb_{0.9}Te₂S, Sb₂Te₂Se, Bi₂(Te,Se)₂(Se,S), TlBiSe₂, TlBiTe₂, TlBi(S,Se)₂, PbBi₂Te₄, PbSb₂Te₄, GeBi₂Te₄, PbBi₄Te₇, GeBi₄₋ₓSbₓTe₇, (PbSe)₅(Bi₂Se₃)₆, (Bi₂)(Bi₂Se_{2.6}S_{0.4}), (Bi₂)(Bi₂Te₃)₂, SnTe, Pb₁₋ₓSnₓTe, Pb_{0.77}Sn_{0.23}Se, Ag₂Te, SmB₆, Bi₁₄Rh₃I₉, Pb₅Bi₂₄Se₄₁ and other topological insulators, along with an adjacent phase selected from metal, semiconductor, dielectric, superconductor, ferromagnetic, antiferromagnetic, ferroelectric, other topological insulator.

The invention provides the following benefits:
- It makes it possible to produce three-dimensional composite micro/nanostructures through directional crystallization, during which, as a result of the self-organization mechanism, a composite containing two or more phases forming heterostructures is formed from a single-phase liquid of eutectic/ supereutectic / subeutectic composition;
- The application of the method according to the invention in topological insulator technology is a promising way to overcome the known state-of-the-art limitations of Tl;
- The method according to the invention allows easy control of the Tl surface-to-volume ratio;
- In a favorable variant of execution, the microstructure of the obtained composites (i.e., heterostructures according to the invention) is lamellar in nature, i.e., multilayered, and the multilayered structure provides protection of the surface states from degradation (from the oxidation process by covering each surface with another phase); On the other hand, the method according to the invention makes it possible to obtain also structures of a different nature, e.g., fibrous (micro/nanofibers), spherical (micro/nanospheres), micro/nanoplates and other geometries;
- A significant advantage of the method according to the invention for producing heterostructures over top-down techniques is the possibility of obtaining a highly crystalline two- or multiphase material with controlled microstructure dimensions in a one-step process. This significantly reduces the time, energy, and cost intensity of the process;
- In the method according to the invention, a variety of crystallization methods can be used to crystallize volumetric materials (such as the Czochralski method, the Bridgman method, the Vertical Gradient Freeze method, the Floating Zone method and related methods), or methods to macroscopically obtain fibers or other shapes (such as the micro-extraction method), or methods to macroscopically obtain layers or to coat the surface with a layer of material;
- In the method according to the invention, almost any type of materials can be used as intermingling with the Tl phase in the heterostructure, including semiconductors, metals, other Tl, and materials with special properties (ferroelectric, ferromagnetic, superconductors, optically active, etc.);
- The use of different components in the method according to the invention to form the heterostructure makes it possible to control the phenomena of charge transport and spin;
- In the method according to the invention, the fragmentation of the heterostructure can be controlled from several hundred micrometers through single micrometers to the nanoscale by changing the growth rate;
- By the method according to the invention, heterostructures with defect-free and sharp interfacial boundaries can be obtained,
- The method according to the invention provides for the possibility of modifying the properties of heterostructures by doping, annealing, etching, laser treatment, application of an external field, etc;
- In one advantageous variant of the invention, the heterostructure according to the invention can be constructed from multiple layers of TI insulator separated by a phase with other electrical properties, which allows increasing the ratio of surface electrons to volume electrons, and the metallic surface states are protected from degradation during operation (at the interface between Tl and another material);
- The heterostructure according to the invention has a high ratio of the surface area of the topological material (including a large number of interfacial boundaries) to the total volume compared to a TI crystal;
- The use of high atomic weight elements (e.g. Bi, Te, Sb) in the composition of the eutectic compound ensures strong spin-orbit coupling.

The invention is shown in examples of embodiment in the figure, in which:

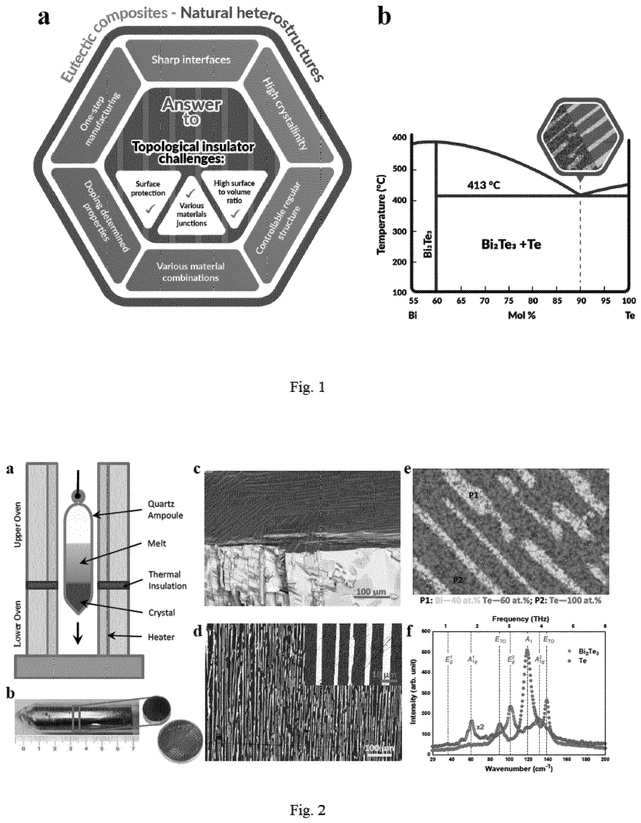

Fig. 1 shows eutectic heterostructures, where (a) shows the advantages of eutectic composites (EC) as natural Tl heterostructures, while (b) shows a phase diagram for the Bi₂Te₃-Te eutectic system, showing one of the eutectics containing the Tl phase;
Fig. 2 shows a natural eutectic Bi₂Te₃-Te heterostructure with a Tl phase, where (a) shows a schematic of a modified VB method to produce volumetric ECs, (b) shows the grown eutectic composite and a polished sample cut perpendicular to the growth direction, (c, d) shows the microstructure of the composite as observed by scanning electron microscopy, with (c) showing the composite, intentionally broken to show the phase arrangement throughout the thickness of the sample - a 45° view and (d) showing the lamellar structure of the composite; white lamellae - Bi₂Te₃, black matrix - Te; (e, f) show inset - close-up and microscale phase identification, where (e) is a map showing the atomic content made by energy dispersive spectroscopy (EDS), (red - Te, green - Bi), while (f) shows micro-Raman spectra of Bi₂Te₃ lamellae and Te matrix with their respective active Raman moduli, where the Bi₂Te₃ spectrum has been scaled 2 times for clarity;

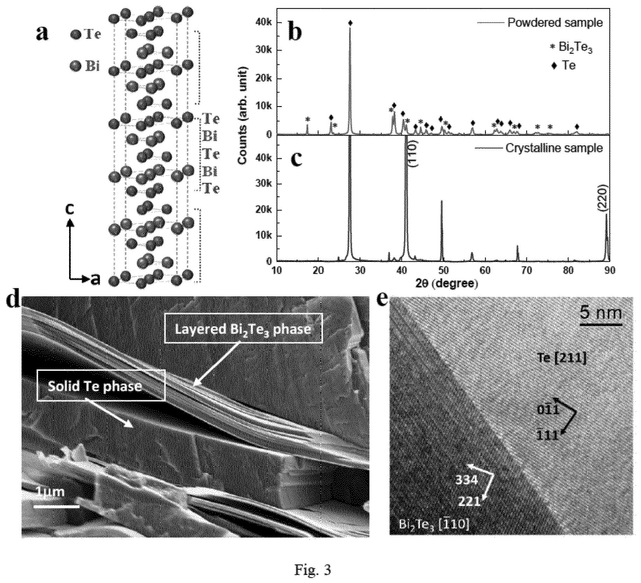

Fig. 3 shows sharp, atomically smooth interfacial boundaries between Bi₂Te₃ and Te lamellae in the Bi₂Te₃-Te eutectic heterostructure, where (a) is a visualization of the layered Bi2Te₃ crystal structure formed by Te-Bi-Te-Bi-Te quintuplets, (b, c) shows the identification of (b) phases and (c) their growth direction by X-ray diffraction showing a single orientation for the Bi₂Te₃ phase, (d) shows an SEM image of the broken sample showing the layered structure of the Bi₂Te₃ phase and smooth boundaries between phases, (e) shows a high-resolution electron tomography HRTEM image of the Te∥Bi₂Te₃ interfacial boundary, where the visible layers of quintuplets are parallel to the interfacial boundary, highlighted in red;

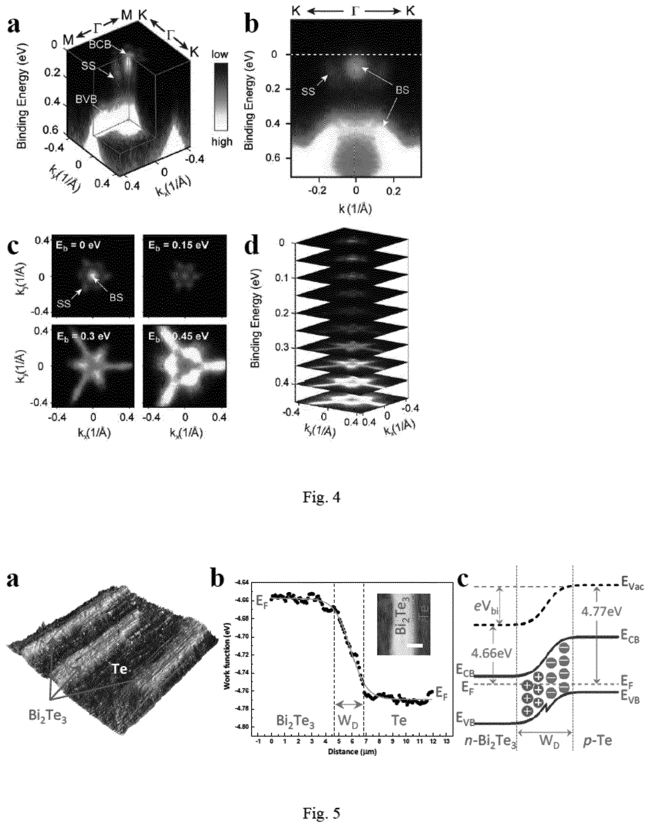

Fig. 4 shows the surface states (SS) in the eutectic Bi₂Te₃-Te heterostructure observed by µARPES, where (a) shows the band structure studied on Bi₂Te₃ lamellae with a photon energy of 74 eV, illustrating the dispersion of the topological SS states, bulk conduction band (BCB) and bulk valence band (BVB), (b) shows a highly symmetric cut of the band dispersion along the K-Γ-K direction, clearly revealing the gap state and Dirac cone shape of the topological SS in the gap, (c) shows the constant energy contours extracted at different binding energies from the full ARPES mapping, showing the evolution of the band structure, (d) shows a slice plot of the constant energy contours;
Fig. 5 shows a KPFM study of a p-n junction in a Bi₂Te₃(n)-Te(p) eutectic heterostructure, where (a) is a 3D CPD profile showing the surface potential of the Te matrix with darker contrast, showing ~110 mV lower value with respect to the Bi₂Te₃ lamellae, (b) Change in work function along the Bi₂Te₃-Te junction showing the absolute position of the Fermi energy in the lamellae and matrix, with the inset showing a 2D CPD plot of the heterostructure with the line profile area highlighted, the orange line is aligned with the sigmoidal curve, and the profile also shows how the surface potential changes along the depletion width (WD), (c) shows a schematic electronic band diagram of the p-n junction formed at the Bi₂Te₃-Te interface, with the absolute positions of the Fermi energy levels (E_{F}) relative to the vacuum energy levels (E_{Vac}) shown along with the embedded potential (V_{bi}) of the junction;

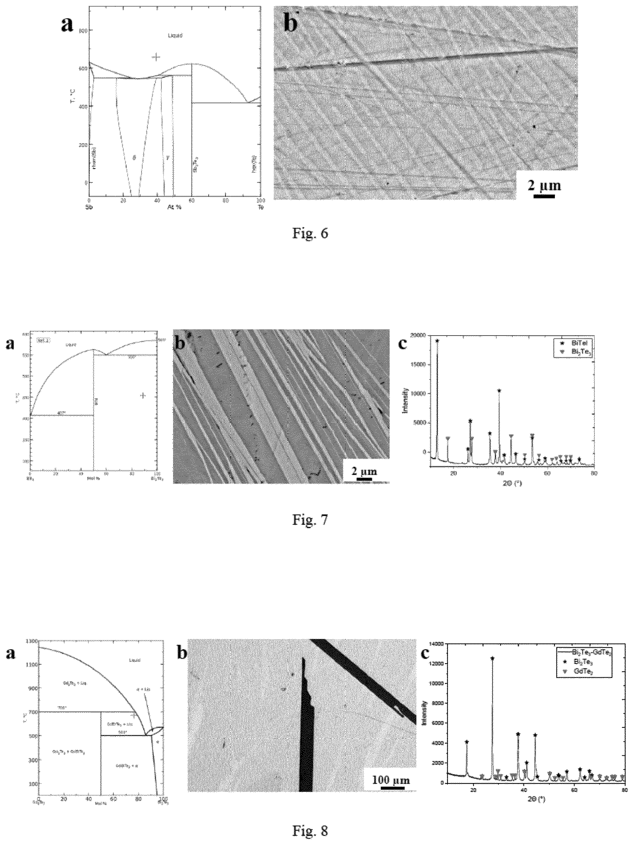

Fig. 6 shows the natural eutectic Tl heterostructure of Sb₂Te₃-Te, where (a) shows the phase diagram of the described Sb₂Te₃-Te system, where (b) shows the lamellar structure of the Sb₂Te₃-Te composite; lamellae - Sb₂Te₃, matrix - Te;
Fig. 7 shows the natural eutectic Tl heterostructure of Bi₂Te₃-BiTeI, where (a) is the phase diagram of the Bi₂Te₃-BiI₃ system, (b) is the lamellar structure of the Bi₂Te₃-BiTeI composite; lamellae - Bi₂Te₃, matrix - BiTel, (c) is the XRD spectrum of the composite clearly shows the presence of the constituent phases;
Fig. 8 shows the natural eutectic Tl heterostructure of Bi₂Te₃-GdBiTe₃. (a) Phase diagram of the Bi₂Te₃-Gd₂Te₃ system, where (b) shows the lamellar structure of the Bi₂Te₃-GdTe₂ composite; black lamellae - GdTe₂, white matrix - Bi₂Te₃, (c) shows the XRD spectrum of the composite clearly shows the presence of the constituent phases;

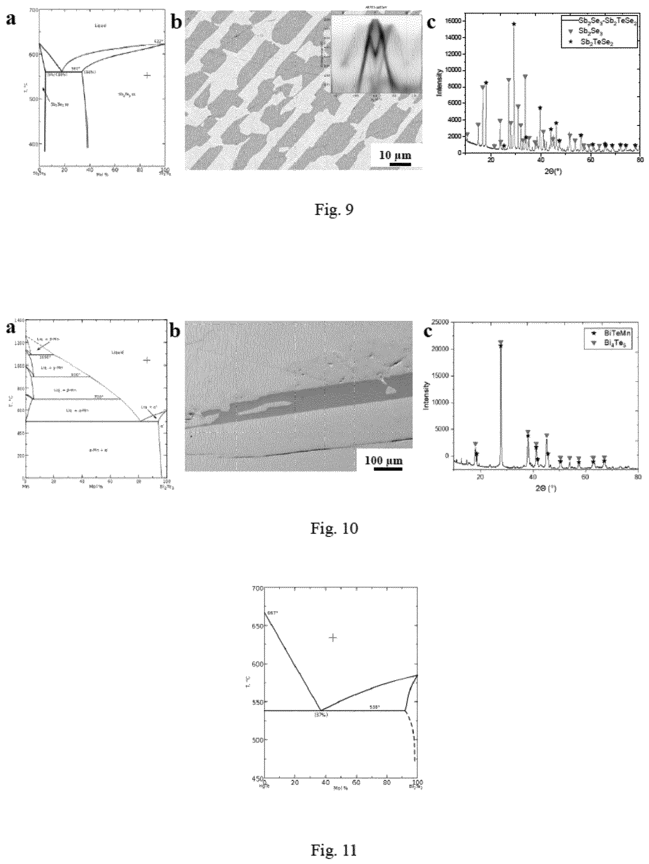

Fig. 9 shows the natural eutectic Tl heterostructure of Sb₂Se₃-Sb₂TeSe₂, where (a) shows the phase diagram of the Sb₂Te₃-Sb₂Se₃ system, (b) shows the lamellar structure of the composite; white lamellae - Sb₂TeSe₂, black matrix - Sb2Te₃. Inset - topological SS in the Sb₂TeSe₂ phase, (c) shows the XRD spectrum of the composite clearly shows the presence of the constituent phases;
Fig. 10 shows the natural eutectic Tl heterostructure of Bi₂Te₃-Mn, where (a) shows the phase diagram of the Bi₂Te₃-Mn system, where (b) shows the lamellar structure of the Bi₄Te₅-BiTeMn composite; black laths - Bi₄Te₅, white matrix - BiTeMn, where (c) shows the XRD spectrum of the composite clearly shows the presence of the constituent phases;
Fig. 11 shows the phase diagram of the natural eutectic Tl heterostructure of Bi₂Te₃-HgTe;

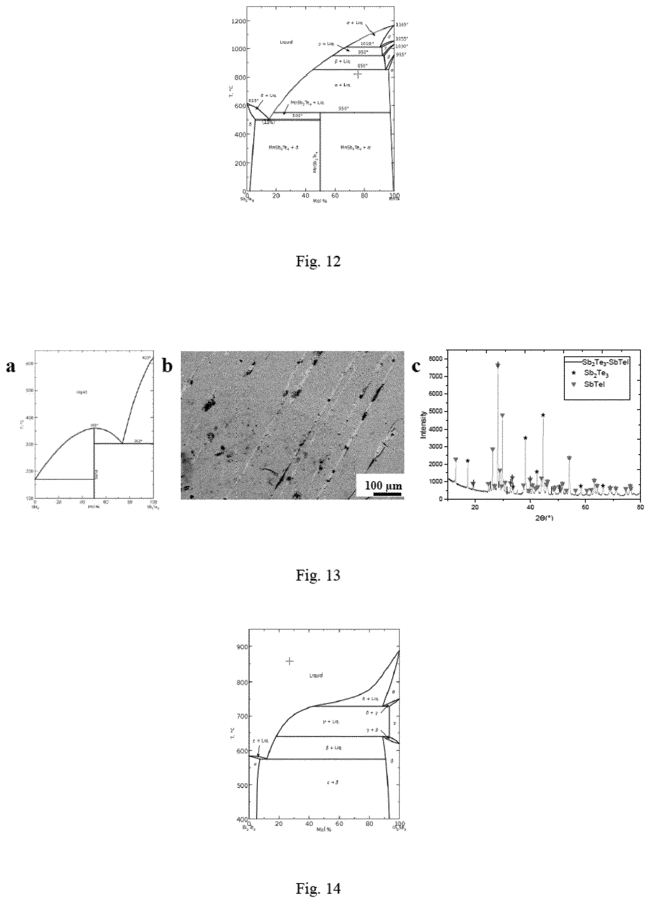

Fig. 12 shows the phase diagram of the natural eutectic Tl heterostructure of Sb₂Te₃-MnSb₂Te₄;
Fig. 13 shows the natural eutectic Tl heterostructure of Sb₂Te₃-SbTeI, where (a) shows the phase diagram of the Sb₂Te₃-SbI₃ system, (b) shows the lamellar structure of the Sb₂Te₃-SbTeI composite, and (c) the XRD spectrum of the composite clearly shows the presence of the constituent phases;
Fig. 14 shows the phase diagram of the natural eutectic Tl heterostructure Bi₂Te₃-In₂Se₃;

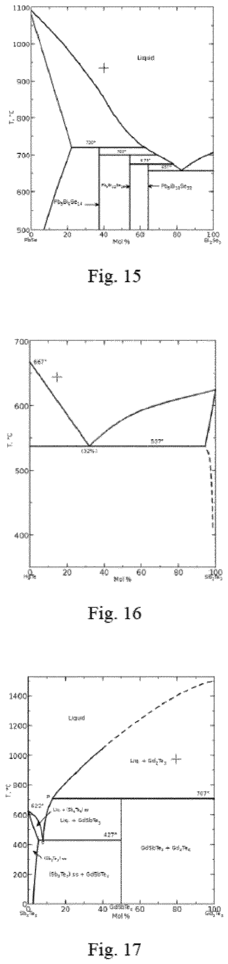

Fig. 15 shows a phase diagram of the natural eutectic Tl heterostructure Bi₂Se₃-PbBi₄Se₇;
Fig. 16 shows a phase diagram of the natural eutectic Tl heterostructure Sb₂Te₃-HgTe;
Fig. 17 shows a phase diagram of the natural eutectic Tl heterostructure Sb₂Te₃-GdSbTe₃;

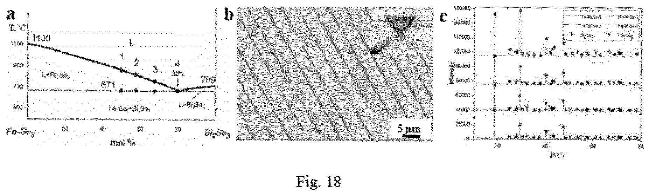

Fig. 18 shows the natural eutectic Tl heterostructure of Bi₂Se₃-Fe₇Se₈, where (a) shows the prepared phase diagram of the Bi₂Se₃-Fe₇Se₈ system, where (b) shows the lamellar structure of the Bi₂Se₃-Fe₇Se₈ composite; black lamella - Fe₇Se₈, white matrix - Bi₂Se₃. Inset - topological SS in the Bi₂Se₃ phase, where (c) shows the XRD spectrum of the composite clearly shows the presence of component phases in many samples.

### Example 1.

In this example of preparation of a volumetric TI heterostructure, a bismuth-tellurium system was made, in which one phase is a 3D topological insulator - bismuth telluride (Bi₂Te₃) and the other is tellurium (Te). They form a eutectic mixture (Fig. 1). The material for synthesis is prepared in appropriate proportions: 85% wt. Te and 15% wt. Bi, (corresponding to 90% mol. Te and 10% mol. Bi). The result is a mixture of 31% wt. Bi₂Te₃ and 69% wt. Te, which corresponds to 27% Bi₂Te₃ and 73% Te volume shares in the composite. The eutectic monocrystal was obtained by directional crystallization using a modified vertical Bridgman technique (*Hruban A, Strzelecka SG, Materna A, Wo* 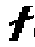 *oś A, Jurkiewicz-Wegner E, Piersa M, et al. Reduction of bulk carrier concentration in Bridgman-grown Bi2Se3 topological insulator by crystallization with Se excess and Ca doping. Journal of Crystal Growth 2014, 407:* 63-67; *doi:10.1016*/*j.jcrysgro.2014.08.026*).

The resulting volumetric eutectic composite exhibits a layered/lamellar microstructure, shown in Fig. 2, where the Bi₂Te₃ phase (white color), is embedded in a Te matrix (black color).

The eutectic micro/nanostructure can be controlled by the crystallization rate.

Applying a higher crystallization rate, according to the formula λ²ν= const. (where v is the growth rate and λ is the distance between layers) results in smaller separation sizes of individual phases and smaller distances between them. At the applied growth rates of 1.2 mm/h to 20 mm/h, Bi₂Te₃ lamellae widths of ~1mm to 85mm and distances between them of ~4mm to ~180mm were obtained.

The microstructure obtained by the method described in the example is characterized by a smooth and sharp interfacial interface as can be seen in Fig. 3. The interface shows no precipitates or defects.

A p-n junction is formed at the Bi₂Te₃-Te phase interface. The band diagram of the junction is illustrated in Fig.4. Bi₂Te₃ is an n-type semiconductor, while Te is a p-type. The width of the WD depleted layer is between 1.5 and 2 µm. There is effective charge separation in the junction area, which allows the formation of electron surface states.

The example presented above demonstrates that the applied method of obtaining heterostructured eutectic composites according to the invention makes it possible to produce functional heterojunctions of Tl material, which can find application in future topological electronic devices.

### Example 2.

Using a similar method as in Example 1, a eutectic composite of Sb₂Te₃-Te (see fig. 6) was obtained, with a volume ratio of about 24:76, using the phase diagram described in the paper Guo et al. 2015 (C.P. Guo, L. Huang, C.R. Li, SL Shang i Z.M. Du, J. Electron. Mater. 2015; 44(8): 2638- 2650*).*

### Example 3.

Using a similar method as in Example 1, Bi₂Te₃-BiTeI (see fig. 7) was obtained, in a volume ratio of about 30:70, using the phase diagram described in Ahmadov et al. 2021 (E. J. Ahmadov, A. N. Mammadov, S. A. Guliyeva, and M. β. Babanly, New Mater., Compd. Appl. 2021,5(1) 5-11*).*

### Example 4.

Using a similar method as in Example 1, heterostructured eutectic/ supereutectic / subeutectic Bi₂Te₃-GdBiTe₃ composites (see fig. 8) are obtained, with a volume ratio of about 83:17, using the phase diagram described in the 2005 publication by Maksudov and Aliev (T. F. Maksudova and O. M. Aliev, Kim. Probl. J., 2005; 1, 37-43*).*

### Example 5.

Using a similar method as in Example 1, heterostructured eutectic/ supereutectic / subeutectic Sb₂Se₃-Sb₂TeSe₂ composites are obtained (see fig. 9), in a volume ratio, approximately 82:18, using the phase diagram described in the 1964 publication by Ivliev and Abrikosov (Ivlieva and N. Kh. Abrikosov, Dokl. Akad. Nauk SSSR, 159 [6] 1326-1329 (1964*);* Dokl. Chem. (Engl. Transl.), 159 (6): 1358-1361*).*

### Example 6.

Using a similar method as in Example 1, heterostructured eutectic/ supereutectic / subeutectic Bi₂Te₃-Mn composites are obtained (see fig. 10), with a volume ratio of about 82:18, using the phase diagram described in the 2011 publication by Azhdarov et al. (D. S. Azhdarova, T. F. Maksudova, S. A. Mekhtieva, and F. R. Babaev, Azerb. Khim. Zh., 2011, 1: 66-68*).*

### Example 7.

Using a similar method as in Example 1, heterostructured eutectic/ supereutectic / subeutectic Bi₂Te₃-HgTe composites are obtained (see fig. 11), with a volume ratio, about 37:63, using the phase diagram described in the 1979 work of Babanly et al. (M. B. Babanly, A. A. Kurbanov, and A. A. Kuliev, Zh. Neorg. Khim., 24 [8] 2293-2294 (1979*);* Russ. J. Inorg. Chem. (Engl. Transl.), 24 [8] 1273-1274*).*

### Example 8.

Using a similar method as in Example 1, eutectic/supereutectic/subeutectic heterostructures of Sb₂Te₃-MnSb₂Te₄ composites (see fig. 12) are obtained, with a volume ratio of about 85:15, using the phase diagram described in the 1982 work of Azhdarov et al. (D. S. Azhdarova, P. G. Rustamov, I. I. Aliev, and M. G. Safarov, Zh. Neorg. Khim., 27 [6] 1608-1610 (1982*);* Russ. J. Inorg. Chem. (Engl. Transl.), 27 [5 6] 909-910*).*

### Example 9.

Using a similar method as in Example 1, heterostructured eutectic/ supereutectic / subeutectic Sb₂Te₃-SbTeI composites are obtained (see fig. 13), with a volume ratio, about 74:26, using the phase diagram described in the 1970 publication by Belotskii et al. (D. P. Belotskii, S. M. Dodik, I. N. Antipov, and Z. I. Nefedova, Ukr. Khim. Zh. (Russ. Ed.), 36 [9] 897-900 (1970*);* Sov. Progr. Chem. (Engl. Transl.), 36 [9] 27-29*).*

### Example 10.

Using a similar method as in Example 1, heterostructured eutectic/ supereutectic / subeutectic Bi₂Te₃-In₂Se₃ composites are obtained (see fig. 14), in a volume ratio, about 88:12, using the phase diagram described in the 1974 publication by Abrikosov and Makareeva (N. Kh. Abrikosov and E. G. Makareeva, Izv. Akad. Nauk SSSR, Neorg. Mater., 10 [7] 1200-1203 (1974*);* Inorg. Mater. (Engl. Transl.), 10 [7] 1029-1031*).*

### Example 11.

Using a similar method as in Example 1, eutectic/ supereutectic / subeutectic heterostructures of Bi₂Se₃-PbBi₄Se₇ composites (see fig. 15) are obtained, with a volume ratio of about 82:18, using the phase diagram described in the 2010 publication by Shelimov et al. *(*L. E. Shelimova, O. G. Karpinskii, P. P. Konstantinov, E. S. Avilov, M. A. Kretova, G. U. Lubman, I. Yu. Nikhezina, and V. S. Zemskov, Neorg. Mater., 46 [2] 158-164 (2010*);* Inorg. Mater. (Engl. Transl.), 46 [2] 120-126*).*

### Example 12.

Using a similar method as in Example 1, heterostructured eutectic/ supereutectic / subeutectic Sb₂Te3-HgTe composites (see fig. 16) are obtained in a volume ratio, 32:68, using the phase diagram described in Babanly et al. 1979 (M. B. Babanly, A. A. Kurbanov, and A. A. Kuliev, Zh. Neorg. Khim., 24 [8] 2293-2294 (1979*);* Russ. J. Inorg. Chem. (Engl. Transl.), 24 [8] 1273-1274*).*

### Example 13.

Using a method similar to Example 1, heterostructured eutectic/ supereutectic / subeutectic Sb₂Te₃-GdSbTe₃ composites are obtained (see fig. 17), with a volume ratio of about 92:8, using the phase diagram described in Bakhtiyarli et al. 2006 (I. B. Bakhtiyarli, R. A. Ismailova, and G. R. Qurbanov, Kim. Probl. J., 2006, No. 2, 396-398*).*

### Example 14.

Using a method similar to that of Example 1, heterostructured eutectic/ supereutectic / subeutectic Bi₂Se₃-Fe₇Se₈ composites with a volume ratio of 80:20 are obtained using a freshly prepared phase diagram as shown in fig. 18.

With that said, the above manufacturing examples are for illustrative purposes only and in no way limit the subject matter of the invention substantiated in the patent claims. It should be noted here that using a similar method as in example 1, heterostructured eutectic/ supereutectic / subeutectic composites with any topological phase together with an adjacent phase in any specified volume ratio are obtained.

A topological phase can be Bi₂Te₃, Bi₂Se₃, Sb₂Te₃, Bi₁₋ₓSbₓ, Bi₂Te₂Se, (Bi,Sb)₂Te₃, Bi₂₋ₓSbₓTe_{3-y}Se_{y}, Bi₂Te_{1.6}S_{1.4}, Bi_{1.1}Sb_{0.9}Te₂S, Sb₂Te₂Se, Bi₂(Te,Se)₂(Se,S), TlBiSe₂, TlBiTe₂, TlBi(S,Se)₂, PbBi₂Te₄, PbSb₂Te₄, GeBi₂Te₄, PbBi₄Te₇, GeBi₄₋ₓSbₓTe₇, (PbSe)₅(Bi₂Se₃)₆, (Bi₂)(Bi₂Se_{2.6}S_{0.4}), (Bi₂)(Bi₂Te₃)₂, SnTe, Pb₁₋ₓSnₓTe, Pb_{0.77}Sn_{0.23}Se, Ag₂Te, SmB₆, Bi₁₄Rh₃I₉, Pb₅Bi₂₄Se₄₁ and any other topological insulator.

The neighboring phase can be a metal, semiconductor, dielectric, superconductor, ferromagnetic, antiferromagnetic, other topological insulator, etc.

In addition, using a similar method as in Example 1, it is also possible to obtain a heterostructured spinoid composite with any topological phase (described earlier) along with neighboring phases (described earlier) in any specified volume ratio.

A topological phase can be Bi₂Te₃, Bi₂Se₃, Sb₂Te₃, Bi₁₋ₓSbₓ, Bi₂Te₂Se, (Bi,Sb)₂Te₃, Bi₂₋ₓSbₓTe_{3-y}Se_{y}, Bi₂Te_{1.6}S_{1.4}, Bi_{1.1}Sb_{0.9}Te₂S, Sb₂Te₂Se, Bi₂(Te,Se)₂(Se,S), TlBiSe₂, TlBiTe₂, TlBi(S,Se)₂, PbBi₂Te₄, PbSb₂Te₄, GeBi₂Te₄, PbBi₄Te₇, GeBi₄₋ₓSbₓTe₇, (PbSe)₅(Bi₂Se₃)₆, (Bi₂)(Bi₂Se_{2.6}S_{0.4}), (Bi₂)(Bi₂Te₃)₂, SnTe, Pb₁₋ₓSnₓTe, Pb_{0.77}Sn_{0.23}Se, Ag₂Te, SmB₆, Bi₁₄Rh₃I₉, Pb₅Bi₂₄Se₄₁ and any other topological insulator.

The neighboring phase can be a metal, semiconductor, dielectric, superconductor, ferromagnetic, antiferromagnetic, other topological insulator, etc.

Using a similar method as in Example 1, it is also possible to obtain heterostructured eutectic/ supereutectic / subeutectic composites with a topological phase along with other various adjacent phases, in any specified volume ratio.

A topological phase can be Bi₂Te₃, Bi₂Se₃, Sb₂Te₃, Bi₁₋ₓSbₓ, Bi₂Te₂Se, (Bi,Sb)₂Te₃, Bi₂₋ₓSbₓTe_{3-y}Se_{y}, Bi₂Te_{1.6}S_{1.4}, Bi_{1.1}Sb_{0.9}Te₂S, Sb₂Te₂Se, Bi₂(Te,Se)₂(Se,S), TlBiSe₂, TlBiTe₂, TlBi(S,Se)₂, PbBi₂Te₄, PbSb₂Te₄, GeBi₂Te₄, PbBi₄Te₇, GeBi₄₋ₓSbₓTe₇, (PbSe)₅(Bi₂Se₃)₆, (Bi₂)(Bi₂Se_{2.6}S_{0.4}), (Bi₂)(Bi₂Te₃)₂, SnTe, Pb₁₋ₓSnₓTe, Pb_{0.77}Sn_{0.23}Se, Ag₂Te, SmB₆, Bi₁₄Rh₃I₉, Pb₅Bi₂₄Se₄₁ and any other topological insulator.

The neighboring phase can be a metal, semiconductor, dielectric, superconductor, ferromagnetic, antiferromagnetic, other topological insulator, etc.

## Claims

1. A method for producing a three-dimensional TI micro- or nano-heterostructure, **characterized in that** a directional crystallization of a single-phase liquid with a eutectic, peri-eutectic, i.e., super-eutectic or sub-eutectic composition into at least two-phase composite heterostructures is carried out, wherein the resulting composite heterostructures contain a topological insulator Tl and another material, which other material is selected from a group including one or more insulator, semiconductor, metal, other Tl, ferroelectric material, ferromagnetic material, superconductor, optically active material.

2. The method according to claim 1, is **characterized in that** the IT insulator is selected from the group including Bi₂Te₃, Bi₂Se₃, Sb₂Te₃, Bi₁₋ₓSbₓ, Bi₂Te₂Se, (Bi,Sb)₂Te₃, Bi₂₋ₓSbₓTe_{3-y}Se_{y}, Bi₂Te_{1.6}S_{1.4}. Bi_{1.1}Sb_{0.9}Te₂S, Sb₂Te₂Se, Bi₂(Te,Se)₂(Se,S), TlBiSe₂, TlBiTe₂, TlBi(S,Se)₂, PbBi₂Te₄, PbSb₂Te₄, GeBi₂Te₄, PbBi₄Te₇, GeBi₄₋ₓSbₓTe₇, (PbSe)₅(Bi₂Se₃)₆, (Bi₂)(Bi₂Se_{2.6}S_{0.4}), (Bi₂)(Bi₂Te₃)₂, SnTe, Pb₁₋ₓSnₓTe, Pb_{0.77}Sn_{0.23}Se, Ag₂Te, SmB₆, Bi₁₄Rh₃I₉, Pb₅Bi₂₄Se₄₁.

3. The method according to claim 1 or 2, **characterized in that** another material is selected from the group comprising Te, Mn, Au, BiTel, GdTe₂, Sb₂Se₃, SbTel, Fe₇Se₈, FeSe, GdBiTe₃, MnSb₂Te₄, HgTe, In₂Se₃, SnBi₄Te₇, EuBi₄Te₇, CdSe, HgSe, MnSb₄Te₇.

4. The method according to any of the preceding claims 1 to 3, is **characterized in that** the speed of directional crystallization was from 0.04 mm/hr to 200 mm/hr, advantageously is 25 mm/hr.

5. The method according to any of the preceding claims 1 to 4, is **characterized in that** the substrates used for directional crystallization are selected from the group including Bi, Te, Se, Sb, PbTe, GeTe, SnTe, PbSe, Ag₂Te, Sm, B, Tl₂Se, Tl₂Te₃, SbI₃, BiI₃.

6. A three-dimensional Tl micro or nanoheterostructure produced by the method specified in claims 1-5, **characterized that** is multilayered and is a eutectic, periautectic, super-eutectic or sub-eutectic composite comprising at least two crystalline phases comprising a Tl phase and a phase of another material, which another material is selected from the group comprising one or more of an insulator, a semiconductor, a metal, another Tl, a ferroelectric material, a ferromagnetic material, a semiconductor, an optically active material.

7. The three-dimensional micro or nanoheterostructure of Tl according to claim 6, is **characterized in that** the Tls are in the form of micro/nanofibers, micro/nanoplates, micro/nanospheres or formations of other shapes, from materials with topologically protected surface states.

8. The three-dimensional micro or nanoheterostructure of Tl according to claims 6 or 7, is **characterized in that** it contains the elements Bi, Te, Sb, or a combination thereof.

9. The three-dimensional micro or nanoheterostructure of Tl according to any of the preceding claims 6-8, is **characterized in that** it is a eutectic/ supereutectic / subeutectic Bi₂Te₃-Te composite, advantageously in a volume ratio of about 31:69.

10. The three-dimensional micro or nanoheterostructure of Tl according to any of the preceding claims 6-8, is **characterized in that** it is a eutectic/ supereutectic / subeutectic composite of Sb₂Te₃-Te, advantageously in a volume ratio of about 24:76.

11. The three-dimensional micro or nanoheterostructure of Tl according to any of the preceding claims 6-8, is **characterized in that** it is a eutectic/ supereutectic / subeutectic Bi₂Te₃-BiTeI composite, advantageously in a volume ratio of about 30:70.

12. The three-dimensional micro or nanoheterostructure of Tl according to any of the preceding claims 6-8, is **characterized in that** it is a eutectic/ supereutectic / subeutectic Bi₂Te₃-GdBiTe₃ composite, advantageously in a volume ratio of about 83:17.

13. The three-dimensional micro or nanoheterostructure of Tl according to any of the preceding claims 6-8, is **characterized in that** it is a eutectic/ supereutectic / subeutectic composite of Sb₂Se₃-Sb₂Te₃, advantageously in a volume ratio of about 82: 18.

14. The three-dimensional micro or nanoheterostructure of Tl according to any of the preceding claims 6-8, is **characterized in that** it is a eutectic/ supereutectic / subeutectic Bi₂Te₃-HgTe composite, advantageously in a volume ratio of about 37:63.

15. The three-dimensional micro or nanoheterostructure of Tl according to any of the preceding claims 6-8, is **characterized in that** it is a eutectic/ supereutectic / subeutectic composite of Sb₂Te₃- MnSb₂Te₄, advantageously in a volume ratio of about 85:15.

16. The three-dimensional micro or nanoheterostructure of Tl according to any of the preceding claims 6-8, is **characterized in that** it is a eutectic/ supereutectic / subeutectic composite of Sb₂Te₃-SbTeI, advantageously in a volume ratio of about 74:26.

17. The three-dimensional micro or nanoheterostructure of Tl according to any of the preceding claims 6-8, is **characterized in that** it is a eutectic/ supereutectic / subeutectic Bi₂Te₃-In₂Se₃ composite, advantageously in a volume ratio of about 88:12.

18. The three-dimensional micro or nanoheterostructure of Tl according to any of the preceding claims 6-8, is **characterized in that** it is a eutectic/ supereutectic / subeutectic Bi₂Se₃-PbBi₄Se₇ composite, advantageously in a volume ratio of about 82:18.

19. The three-dimensional micro or nanoheterostructure of Tl according to any of the preceding claims 6-8, **characterized in that** it is a eutectic/ supereutectic / subeutectic composite of Sb₂Te₃-HgTe, advantageously in a volume ratio of about 32:68.

20. The three-dimensional micro or nanoheterostructure of Tl according to any of the preceding claims 6-8, **characterized in that** it is a eutectic/ supereutectic / subeutectic composite of Sb₂Te₃-GdSbTe₃, advantageously in a volume ratio of about 92:8.

21. A three-dimensional micro or nanoheterostructure of Tl according to any of the preceding claims 6-8, **characterized in that** it is a eutectic/ supereutectic / subeutectic composite with a topological phase selected from the Bi₂Te₃, Bi₂Se₃, Sb₂Te₃, Bi₁₋ₓSbₓ, Bi₂Te₂Se, (Bi,Sb)₂Te₃, Bi₂₋ₓSbₓTe_{3-y}Se_{y}, Bi₂Te_{1.6}S_{1.4}, Bi_{1.1}Sb_{0.9}Te₂S, Sb₂Te₂Se, Bi₂(Te,Se)₂(Se,S), TlBiSe₂, TlBiTe₂, TlBi(S,Se)₂, PbBi₂Te₄, PbSb₂Te₄, GeBi₂Te₄, PbBi₄Te₇, GeBi₄₋ₓSbₓTe₇, (PbSe)₅(Bi₂Se₃)₆, (Bi₂)(Bi₂Se_{2.6}S_{0.4}), (Bi₂)(Bi₂Te₃)₂, SnTe, Pb₁₋ₓSnₓTe, Pb_{0.77}Sn_{0.23}Se, Ag₂Te, SmB₆, Bi₁₄Rh₃I₉, Pb₅Bi₂₄Se₄₁ and other topological insulators, along with an adjacent phase selected from metal, semiconductor, dielectric, superconductor, ferromagnetic, antiferromagnetic, ferroelectric, other topological insulator.

22. The three-dimensional micro or nanoheterostructure of Tl according to any of the preceding claims 6-8, **characterized in that** it is a spinoid composite with a topological phase selected from the Bi₂Te₃, Bi₂Se₃, Sb₂Te₃, Bi₁₋ₓSbₓ, Bi₂Te₂Se, (Bi,Sb)₂Te₃, Bi₂₋ₓSbₓTe_{3-y}Se_{y}, Bi₂Te_{1.6}S_{1.4}, Bi_{1.1}Sb_{0.9}Te₂S, Sb₂Te₂Se, Bi₂(Te,Se)₂(Se,S), TlBiSe₂, TlBiTe₂, TlBi(S,Se)₂, PbBi₂Te₄, PbSb₂Te₄, GeBi₂Te₄, PbBi₄Te₇, GeBi₄₋ₓSbₓTe₇, (PbSe)₅(Bi₂Se₃)₆, (Bi₂)(Bi₂Se_{2.6}S_{0.4}), (Bi₂)(Bi₂Te₃)₂, SnTe, Pb₁₋ₓSnₓTe, Pb_{0.77}Sn_{0.23}Se, Ag₂Te, SmB₆, Bi₁₄Rh₃I₉, Pb₅Bi₂₄Se₄₁ and other topological insulators, along with adjacent phases selected from metal, semiconductor, dielectric, superconductor, ferromagnetic, antiferromagnetic, ferroelectric, another topological insulator.

23. The three-dimensional Tl micro or nanoheterostructure according to any of the preceding claims 6-8, **characterized in that** it is a multi-phase eutectic/ supereutectic / subeutectic composite with one topological phase together with other various adjacent phases, the topological phase being selected from the Bi₂Te₃, Bi₂Se₃, Sb₂Te₃, Bi₁₋ₓSbₓ, Bi₂Te₂Se, (Bi,Sb)₂Te₃, Bi₂₋ₓSbₓTe_{3-y}Se_{y}, Bi₂Te_{1.6}S_{1.4}, Bi_{1.1}Sb_{0.9}Te₂S, Sb₂Te₂Se, Bi₂(Te,Se)₂(Se,S), TlBiSe₂, TlBiTe₂, TlBi(S,Se)₂, PbBi₂Te₄, PbSb₂Te₄, GeBi₂Te₄, PbBi₄Te₇, GeBi₄₋ₓSbₓTe₇, (PbSe)₅(Bi₂Se₃)₆, (Bi₂)(Bi₂Se_{2.6}S_{0.4}), (Bi₂)(Bi₂Te₃)₂, SnTe, Pb₁₋ₓSnₓTe, Pb_{0.77}Sn_{0.23}Se, Ag₂Te, SmB₆, Bi₁₄Rh₃I₉, Pb₅Bi₂₄Se₄₁ and other topological insulators, adjacent phases are selected from metal, semiconductor, dielectric, superconductor, ferromagnetic, antiferromagnetic, ferroelectric, other topological insulator.
